# EUROPEAN PATENT APPLICATION

(11) **EP 4 799 506 A1**
(43) Date of publication of application: **02.09.2026**
(21) Application number: 23956829.8
(22) Date of filing: 27.10.2023
(51) Int. Cl.: A24F 40/60

(54) **AEROSOL GENERATION DEVICE AND AEROSOL GENERATION SYSTEM**

(71) Applicant: Japan Tobacco Inc., Tokyo 105-6927 (JP)
(72) Inventor: WAKABAYASHI, Genya, Tokyo 130-8603 (JP)
(74) Representative: Hoffmann Eitle
(86) International application number: PCT/JP2023/038831
(87) International publication number: WO 2025/088778

(57) **Abstract**

An aerosol-generating device comprises: an aerosol-generating portion for generating an aerosol; a battery; a control unit; a display portion; a display window portion functioning as a button; a display portion cover member positioned between the display window portion and the display portion; and a first cushioning material positioned between the display window portion and the display portion cover member.

## Description

### TECHNICAL FIELD

The present invention relates to an aerosol-generating device and to an aerosol-generating system.

### BACKGROUND ART

Aerosol-generating devices for generating an aerosol containing a flavor, etc. without burning of materials are conventionally known. Such aerosol-generating devices or components thereof include a display portion and a window portion through which light from the display portion passes, and may be configured so that the window portion or a member around the window portion functions as a button (e.g., see PTL 1-3). In the power component of PTL 1, a button holder deforms when an external force is applied to a button, and a display screen is electrically connected to a control board.

### CITATION LIST

### PATENT LITERATURE

PTL 1: CN 105024412 A
PTL 2: CN 104432543 A
PTL 3: CN 203121013 U

### SUMMARY OF INVENTION

### PROBLEM TO BE SOLVED BY THE INVENTION

In the electronic cigarette battery device of PTL 2, a button assembly has an elastic member which is compressed when a switch button is pressed. In the electronic cigarette of PTL 3, a switch base is disposed between a key switch and a light-emitting diode (LED). If there is a large space between the window portion and the display portion in devices such as those of PTL 1-3, this runs counter to achieving a compact device and also risks ingress of dust, etc. Meanwhile, if there is a member present between the window portion and the display portion, it may not be possible to protect the display portion for a sufficiently long period of time due to wear, etc. of that member, because the button may be repeatedly pressed.

One objective of the present invention lies in providing an aerosol-generating device or an aerosol-generating system capable of protecting a display portion for a sufficiently long period of time while also having a member disposed between the display portion and a display window portion functioning as a button.

### SOLUTION TO PROBLEM

According to one aspect, an aerosol-generating device is provided. This aerosol-generating device comprises: an aerosol-generating portion for generating an aerosol; a battery; a control unit; a display portion; a display window portion functioning as a button; a display portion cover member positioned between the display window portion and the display portion; and a first cushioning material positioned between the display window portion and the display portion cover member.

The aspect above makes it possible to provide an aerosol-generating device capable of protecting the display portion for a sufficiently long period of time while also having a member disposed between the display portion and the display window portion, by virtue of the fact that the first cushioning material alleviates impacts such as the display window portion being pressed by a user, and distributes pressure.

The first cushioning material may comprise a silicone resin.

In this case, the display portion can be protected for a longer period of time because silicone resin is highly durable.

The aerosol-generating device may further comprise a second cushioning material positioned between the display portion cover member and the display portion.

In this case, the display portion can be protected more reliably because the second cushioning material alleviates impacts transmitted from the display portion cover member, and distributes pressure.

The second cushioning material may comprise an ethylene-vinyl acetate copolymer resin (EVA resin).

In this case, it is possible to provide an aerosol-generating device comprising a display assembly which takes advantage of the lightness and elasticity characteristics of EVA resin.

The second cushioning material may be configured to have a spongy structure, and the first cushioning material may be configured not to have a spongy structure.

In this case, the durability of the first cushioning material which requires higher durability can be easily enhanced, while it is also possible to take advantage of the characteristics of a spongy structure, such as flexibility, for the second cushioning material.

The display portion cover member may comprise at least one of polycarbonate and ABS resin.

In this case, it is possible to provide an aerosol-generating device comprising a display assembly which has outstanding durability and is easily manufactured.

The display portion cover member may comprise a leg portion extending to the opposite side of the display portion to the side on which the display portion cover member is disposed, and the leg portion may be fixed to a chassis or a housing of the aerosol-generating device.

In this case, pressure from pressing of the display window portion can be distributed to the chassis or the housing, making it possible to reduce the adverse effects of such pressure on the display portion.

The aerosol-generating device may further comprise a face having an opening through which a consumable material is inserted, and the display window portion may be arranged on the abovementioned face.

In this case, the display portion can be seen more easily when the user grips a side face or a bottom face of the aerosol-generating device.

The aerosol-generating device may further comprise a tactile switch, and the display window portion may function as the button for switching the tactile switch.

In this case, control by means of the button is enabled while the aerosol-generating device is endowed with a simple configuration.

The aerosol-generating portion may comprise a heating unit for heating an aerosol-generating article, and the control unit may be configured to start heating in the heating unit when the display window portion is continuously pressed for a predetermined time.

In this case, it is possible to reduce the risk of the display window portion which functions as a button being pressed and heating being started by accidental contact.

The display portion may comprise an organic light-emitting diode.

In this case, the user can be provided with a screen having a wide viewing angle and a fast response speed.

The control unit may be configured to display information relating to control of the aerosol-generating device on the display portion.

In this case, information can be transmitted to the user for a sufficiently long period of time by means of the display portion which is protected by the first cushioning material, etc.

The display portion may comprise a screen, and the first cushioning material may extend in a direction in which the screen extends and may have an opening portion at a position facing the screen in a direction perpendicular to the screen.

In this case, pressure can be better distributed and ingress of dust or similar to the optical path of light from the display portion can be inhibited, while the optical path is maintained.

The display portion cover member may be arranged, so as to face a direction perpendicular to the screen, on a member of the display portion arranged so as to surround the screen.

In this case, changes in pressure exerted on the display portion can be reduced while the optical path of light from the display portion is maintained.

According to another aspect, an aerosol-generating system comprising the abovementioned aerosol-generating device and an aerosol-generating article is provided.

The aspect above makes it possible to provide an aerosol-generating system capable of protecting a display portion for a sufficiently long period of time while also having a member disposed between the display portion and a display window portion functioning as a button.

### BRIEF DESCRIPTION OF DRAWINGS

[Fig. 1] is a schematic view in side section showing an aerosol-generating system according to an embodiment.
[Fig. 2] is a plan view showing an aerosol-generating device.
[Fig. 3] is a schematic view in cross section of an aerosol-generating device comprising a display assembly.
[Fig. 4] is an exploded oblique view of a portion of the display assembly.

### EMBODIMENTS OF THE INVENTION

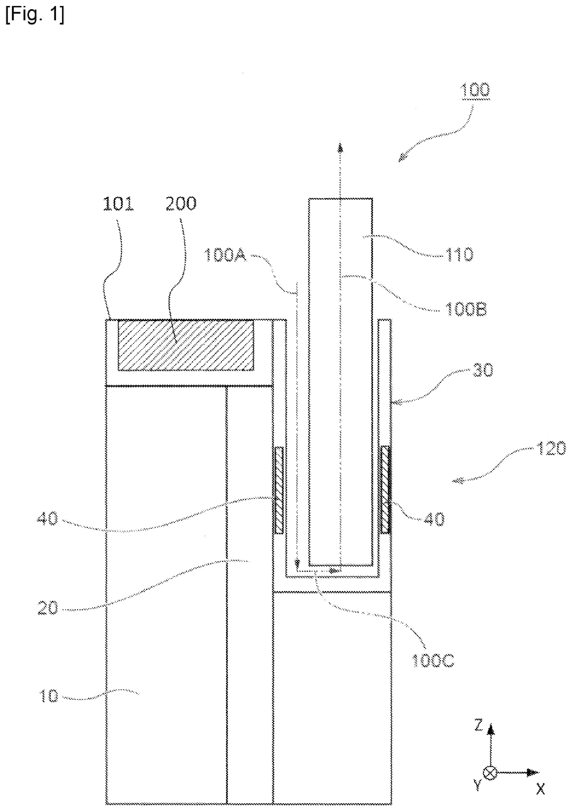

Embodiments of the present invention will be described below with reference to the drawings. In the drawings described below, identical or corresponding components are assigned the same reference symbols and duplicate descriptions will not be given. Fig. 1 is a schematic view in side section showing an aerosol-generating system 100 according to the embodiment. As shown in fig. 1, the aerosol-generating system 100 comprises: a consumable material 110 and an aerosol-generating device 120 for heating the consumable material 110. The consumable material 110 is an aerosol-generating article which comprises a flavor source and is configured so that a flavor-containing aerosol is generated by means of heating. The aerosol-generating device 120 may be a flavor inhaler for a user to inhale a flavor. Air to be inhaled by the user is directed into the oral cavity of the user, for example in the order of air flow 100A, air flow 100C, and air flow 100B. That is to say, the aerosol-generating system 100 shown in fig. 1 has what is known as a counterflow-type air flow path. It should be noted that there is no particular limitation as to the form of flow path for the air to be inhaled, and it may equally be what is known as a bottom-flow form, in which air is introduced into a chamber for accommodating the consumable material 110 from an opening formed in a bottom portion of the chamber, for example.

An X-Y-Z orthogonal coordinate system may be applied to the drawings described in the present specification for convenience of description. In this coordinate system, the Z-axis is oriented vertically upwards, the X-Y plane is arranged cutting across the aerosol-generating device 120 in a horizontal direction, and the Y-axis is arranged extending from the front surface to the rear surface of the aerosol-generating device 120. The Z-axis direction may also refer to a direction of insertion of the consumable material 110 accommodated in an aerosol-generating portion 30. Furthermore, the X-axis direction may also refer to a device longitudinal direction in a plane orthogonal to the direction of insertion of the consumable material 110. The Y-axis direction may also refer to a device short-side direction in a plane orthogonal to the direction of insertion of the consumable material 110.

In this embodiment, the consumable material 110 is a substrate containing a flavor source such as tobacco capable of generating a smokable flavor, and has, for example, a columnar shape extending along the longitudinal direction. The flavor source contained in the consumable material 110 is not particularly limited and may comprise at least one of a natural material such as a plant material, and a flavoring. The consumable material 110 may comprise a filling material obtained by shredding a plant material such as tobacco leaves or processing such material into the form of a sheet. A filling material such as this may be wrapped with paper. The consumable material 110 may be a tobacco stick, for example. The consumable material 110 may have a cylindrical shape, a columnar shape with a polygonal cross section, a flat shape, or a capsule form. It should be noted that there is no particular limitation as to the form of the consumable material 110, which may, for example, be a cartridge containing a liquid comprising the flavor source, or a capsule comprising a solid flavor source such as a powder.

The aerosol-generating device 120 comprises: a battery 10, a control unit 20, and an aerosol-generating portion 30 for generating an aerosol. The battery 10 stores electrical power for use by the aerosol-generating device 120. The battery 10 is a lithium ion battery, for example. The battery 10 may be rechargeable by means of an external power source.

The control unit 20 is configured by a CPU and a memory, etc. and controls operation of the aerosol-generating device 120 including the aerosol-generating portion 30. For example, the control unit 20 starts heating of the consumable material 110 in response to a user operation on a display window portion 210 (to be described later) and terminates heating of the consumable material 110 once a given time has elapsed. When the number of puffing actions by the user has passed a fixed value, the control unit 20 may terminate heating of the consumable material 110 even if the given time has not yet elapsed from the start of heating of the consumable material 110. Puffing actions are detected by a sensor (not depicted), for example.

Alternatively, the control unit 20 may start heating of the consumable material 110 in response to the start of a puffing action, and may terminate heating of the consumable material 110 in response to the end of the puffing action. When a given time has elapsed from the start of the puffing action, the control unit 20 may terminate heating of the consumable material 110 even if the puffing action has not yet finished.

The aerosol-generating portion 30 may be configured to accommodate at least a portion of the consumable material 110. The aerosol-generating portion 30 furthermore comprises a heating unit 40. The heating unit 40 may be a heater disposed in the aerosol-generating device 120. The heater may comprise a heating wire. The heater may heat the consumable material 110 from the outside, as shown in fig. 1, or may heat the consumable material 110 from the inside, as is the case with a pin-type or blade-type heater. There is no particular limitation as to the form of the heating unit 40. The heating unit 40 may be an induction coil for inductively heating a susceptor contained in the consumable material 110. Alternatively, the heating unit 40 may be a microwave radiation source which heats a microwave absorber such as water or glycerol contained in the consumable material 110.

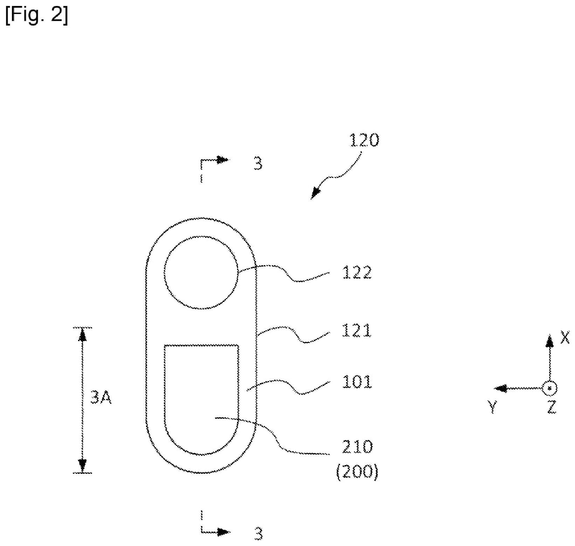

Fig. 2 is a plan view showing the aerosol-generating device 120. As shown in fig. 2, the aerosol-generating device 120 comprises an upper face 101, a display window portion 210 disposed on the upper face 101, and a housing 121. The display window portion 210 forms part of a display assembly 200 which will be described later. The upper face 101 is a face of the aerosol-generating device 120 comprising an opening 122 through which the consumable material 110 is inserted. As will be described later, the display window portion 210 is light transmissive and is configured to allow a display portion 250 to be seen through the display window portion 210. The display window portion 210 is preferably arranged on the upper face 101 so that it can be easily seen when the user grips a side face or a bottom face of the aerosol-generating device 120, but this is not limiting, and the display window portion 210 may be arranged at any position on an outer face of the aerosol-generating device 120.

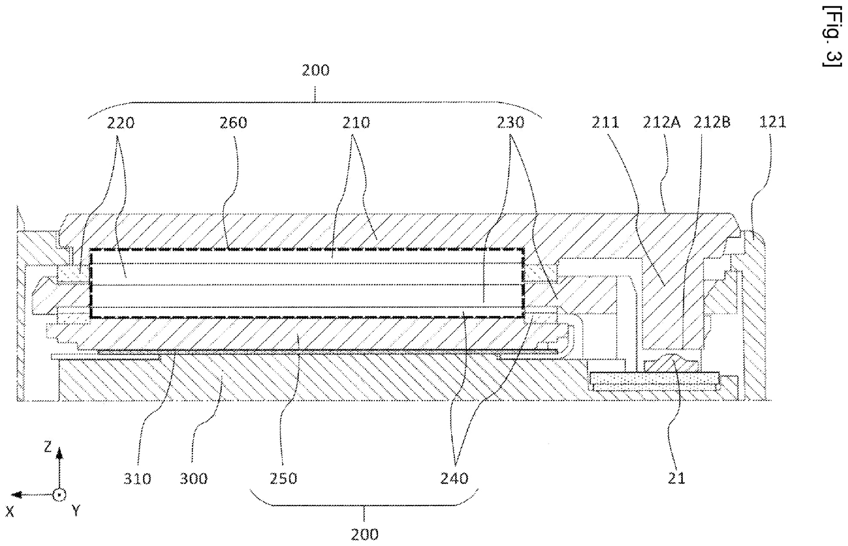

Fig. 3 is a view in cross section of the aerosol-generating device 120 comprising the display assembly 200. Fig. 3 shows a cross section seen along the arrows 3-3 in fig. 2 of the part of the aerosol-generating device 120 denoted by 3A. The display assembly 200 comprises: the display window portion 210, a first cushioning material 220, a display portion cover member 230, a second cushioning material 240, and a display portion 250.

The display window portion 210 comprises a window for allowing light from the display portion 250 to pass to outside of the aerosol-generating device 120. As shown in fig. 3, the display assembly 200 may have a cavity 260 penetrating the first cushioning material 220, the display portion cover member 230, and the second cushioning material 240. In this configuration, light from the display portion 250 is emitted to outside of the aerosol-generating device 120 through the cavity 260 and the display window portion 210. The display window portion 210 preferably defines part of the outer face of the aerosol-generating device 120.

The display window portion 210 is light transmissive. The display window portion 210 is preferably transparent if text or images are displayed on the display portion 250, but the display window portion 210 may be semitransparent. The display window portion 210 preferably comprises a resin such as polycarbonate (PC) or acrylonitrile-butadiene-styrene (ABS), or glass, etc.

As shown in fig. 3, the display window portion 210 has a button portion 211 and functions as a button. The button portion 211 is configured to enable a user to press the button portion 211, and, when pressed by the user, is configured to be capable of inducing a change in an electrical signal in the control unit 20. In the example depicted, the display window portion 210 is a plate-shaped member extending along the outer face of the aerosol-generating device 120, and is flexible at one end in the device longitudinal direction in order to form the button portion 211. The display window portion 210 thus comprises a fixed end which is fixed to the outer face of the aerosol-generating device 120, and a movable end. It should be noted that there is no particular limitation as to the form of the button portion 211, and a plurality of button portions 211 may equally be formed on the display window portion 210, for example.

As shown in fig. 3, the aerosol-generating device 120 has a tactile switch 21. The tactile switch 21 has an ON state when pressed and an OFF state when not pressed, and is configured to generate different electrical signals in a circuit of the control unit 20 in the ON state and the OFF state. For example, the tactile switch 21 is configured to energize the circuit in the ON state and not to energize the circuit in the OFF state. In the example depicted, the button portion 211 comprises a first pressing face 212A that can be pressed by the user, and a second pressing face 212B. The button portion 211 is configured to move by flexing when the user presses the first pressing face 212A, and the second pressing face 212B presses the tactile switch 21 to switch between the ON state and the OFF state. The display window portion 210 thus preferably functions as a button for switching the tactile switch 21. This enables control by means of the button with a simple configuration.

The control unit 20 may be configured to start heating in the heating unit 40 when the button portion 211 of the display window portion 210 is continuously pressed for a predetermined time. There is no particular limitation as to the predetermined time, but it may be set at 1-5 seconds, for example. When the ON state of the tactile switch 21 continues for the predetermined time due to pressing by the user, the control unit 20 causes power from the battery 10 to be supplied to the heating unit 40, causing heating to start. By means of such control, it is possible to reduce the risk of the button portion 211 being pressed and heating being started by accidental brief contact. Moreover, there is no particular limitation as to the forms of control utilizing the button portion 211, and heating may be stopped by the user pressing the button portion 211, for example.

The first cushioning material 220 is cushioning positioned between the display window portion 210 and the display portion cover member 230. The display portion 250 could be subjected to an impact when the display window portion 210 is repeatedly pressed by the user or when the aerosol-generating device 120 is dropped, or the like. The first cushioning material 220 protects the display portion 250 for a sufficiently long period of time by virtue of alleviating impacts and distributing pressure in such cases. The first cushioning material 220 may be freely and suitably selected from elastic members made of resin or the like, but the first cushioning material 220 is subjected to repeated pressure changes and therefore preferably comprises a highly durable material. From this perspective, the first cushioning material 220 preferably comprises a silicone resin. Furthermore, from a similar perspective, the first cushioning material 220 is preferably solid rather than having a spongy structure. A spongy structure here means a porous structure with closed cells or open cells.

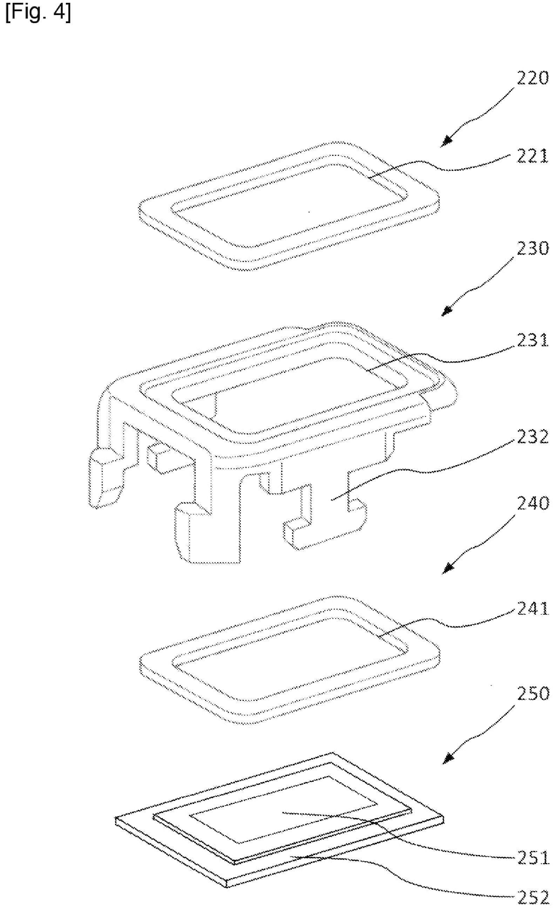

Fig. 4 is an exploded oblique view of the display assembly 200, showing the first cushioning material 220, the display portion cover member 230, the second cushioning material 240, and the display portion 250. As shown in fig. 3 and 4, the first cushioning material 220 extends in the direction in which a screen 251 of the display portion 250 extends. In the example depicted, the first cushioning material 220 extends in a direction perpendicular to the direction of insertion of the consumable material 110. The first cushioning material 220 has a first opening portion 221 at a position facing the screen 251 in a direction perpendicular to the screen 251. The first opening portion 221 is configured so that light from the display portion 250 passes therethrough. There is no particular limitation as to the shape of the first cushioning material 220, but pressure can be better distributed and ingress of dust or similar to the optical path of light from the display portion 250 can be inhibited by forming the first cushioning material 220 in such a way as to surround the screen 251 in a coordinate plane parallel to the screen 251 while maintaining the optical path in this way.

The display portion cover member 230 is a member positioned between the display window portion 210 and the display portion 250, and is a member which covers at least part of the display portion 250. The display portion cover member 230 is preferably configured to support the first cushioning material 220. As shown in fig. 3 and 4, the display portion cover member 230 may be arranged facing a frame member 252 (to be described later) of the display portion 250 in a direction perpendicular to the screen 251. Furthermore, the display portion cover member 230 may have a second opening portion 231 at a position facing the screen 251 in a direction perpendicular to the screen 251. The second opening portion 231 is configured so that light from the display portion 250 passes therethrough. By virtue of such a configuration, the display portion cover member 230 is capable of reducing changes in pressure applied to the display portion 250, for instance by supporting the first cushioning material 220, while maintaining the optical path of light from the display portion 250.

The display portion cover member 230 is preferably rigid. There is no particular limitation as to the material of the display portion cover member 230, and the display portion cover member 230 may comprise a resin, a metal, or a ceramic, etc. From perspectives such as durability and processability, the display portion cover member 230 preferably comprises at least one resin out of PC and ABS.

As shown in fig. 3, the aerosol-generating device 120 may comprise a chassis 300. The chassis 300 functions as a support for the display assembly 200. In the example depicted, the chassis 300 is configured to support the display assembly 200 with an adhesion layer 310 interposed. There is no particular limitation as to the form of adhesion layer 310, which may be a double-sided tape, for example. There is no particular limitation as to the material constituting the chassis 300, but the chassis 300 may comprise a resin such as PC or a metal, etc.

The display portion cover member 230 may be connected to the chassis 300 or the housing 121, and is preferably fixed to the chassis 300 or the housing 121. As shown in fig. 4, the display portion cover member 230 may comprise a leg portion 232 extending to the opposite side of the display portion 250 to the side on which the display portion cover member 230 is disposed (the upper face 101 side), and the leg portion 232 may be fixed to the chassis 300. In the example depicted, a pair of leg portions 232 are formed on the display portion cover member 230, and the pair of leg portions 232 is configured to sandwich the chassis 300 from both sides. The pair of leg portions 232 may be elastic and may be configured to press the chassis 300 from both sides by means of a restoring force. The leg portions 232 may be fixed to the housing 121. By virtue of such a configuration, pressure from pressing of the display window portion 210 can be distributed to the chassis 300 or the housing 121, making it possible to reduce adverse effects on the display portion 250.

The second cushioning material 240 is cushioning positioned between the display portion cover member 230 and the display portion 250. The second cushioning material 240 protects the display portion 250 by alleviating impacts transmitted from the display portion cover member 230, and distributing pressure. The second cushioning material 240 may be freely and suitably selected from elastic members made of resin or the like. The second cushioning material 240 need not be as durable as the first cushioning material 220 because changes in pressure on the second cushioning material 240 are reduced by the display portion cover member 230. For example, the second cushioning material 240 preferably comprises an ethylene-vinyl acetate copolymer resin (EVA resin) from the perspective of lightness or elasticity. Furthermore, the second cushioning material 240 need not have a spongy structure. The first cushioning material 220 preferably has a spongy structure, and the second cushioning material 240 preferably does not have a spongy structure. By this means, the durability of the first cushioning material 220 can be easily enhanced, while it is also possible to take advantage of the characteristics of a spongy structure, such as flexibility, for the second cushioning material 240.

As shown in fig. 3 and 4, the second cushioning material 240 may extend in the direction in which the screen 251 of the display portion 250 extends. In the example depicted, the second cushioning material 240 extends in a direction perpendicular to the direction of insertion of the consumable material 110. The second cushioning material 240 has a third opening portion 241 at a position facing the screen 251 in a direction perpendicular to the screen 251. The third opening portion 241 is configured so that light from the display portion 250 passes therethrough. There is no particular limitation as to the shape of the second cushioning material 240, but pressure can be better distributed and ingress of dust or similar to the optical path of light from the display portion 250 can be inhibited by forming the second cushioning material 240 in such a way as to surround the screen 251 in a coordinate plane parallel to the screen 251 while maintaining the optical path in this way. Furthermore, the display portion 250 may be pressed against the adhesion layer 310 by the elasticity of the second cushioning material 240. The display portion 250 can be made less likely to move by this means.

The display portion 250 is configured to provide a display by emitting light. The display portion 250 comprises at least one of a light-emitting element such as a light-emitting diode (LED), and a screen 251 comprising a plurality of pixels. The display portion 250 preferably comprises an organic light-emitting diode (OLED), and more preferably comprises a screen 251 having OLED pixels. By this means, the user can be provided with a screen 251 having a wide viewing angle and a fast response speed. As shown in fig. 4, the display portion 250 may comprise a frame member 252 which is arranged so as to surround the screen 251 of the display portion 250. There is no particular limitation as to the form of the frame member 252, which may be a display device outer frame. Moreover, the display portion 250 may comprise a liquid crystal display or the like, rather than comprising an OLED.

The control unit 20 is preferably configured to display information relating to control of the aerosol-generating device 120 on the display portion 250. By this means, information can be transmitted to the user for a sufficiently long period of time by means of the display portion 250 which is protected by the first cushioning material 220, etc. For example, the display portion 250 may indicate that the heating unit 40 is heating the consumable material 110 by displaying "heating in progress" on the screen 251, and may indicate the remaining power in the battery 10 by means of color or flashing of a light-emitting element which is not depicted. There is no particular limitation as to the type of information which the control unit 20 displays on the display portion 250.

Embodiments of the present invention were described above, but the present invention is not limited to those embodiments, and various modifications are possible within the scope of the technical concept disclosed in the claims, specification and drawings. Moreover, any shape or material not directly stated in the specification or drawings is also within the scope of the technical concept of the invention of this application, provided that it exhibits the action and effect of the invention of this application.

According to a first aspect of the present invention, an aerosol-generating device comprises: an aerosol-generating portion for generating an aerosol; a battery; a control unit; a display portion; a display window portion functioning as a button; a display portion cover member positioned between the display window portion and the display portion; and a first cushioning material positioned between the display window portion and the display portion cover member.

According to a second aspect of the present invention, which is in accordance with the first aspect, the first cushioning material comprises a silicone resin.

According to a third aspect of the present invention, which is in accordance with the first or second aspect, a second cushioning material positioned between the display portion cover member and the display portion is further provided.

According to a fourth aspect of the present invention, which is in accordance with the third aspect, the second cushioning material comprises an ethylene-vinyl acetate copolymer resin (EVA resin).

According to a fifth aspect of the present invention, which is in accordance with the third or fourth aspect, the second cushioning material has a spongy structure, and the first cushioning material does not have a spongy structure.

According to a sixth aspect of the present invention, which is in accordance with any of the first to fifth aspects, the display portion cover member comprises at least one of polycarbonate and ABS resin.

According to a seventh aspect of the present invention, which is in accordance with any of the first to sixth aspects, the display portion cover member comprises a leg portion extending to the opposite side of the display portion to the side on which the display portion cover member is disposed, and the leg portion is fixed to a chassis or a housing of the aerosol-generating device.

According to an eighth aspect of the present invention, which is in accordance with any of the first to seventh aspects, the aerosol-generating device further comprises a face having an opening through which a consumable material is inserted, and the display window portion may be arranged on the abovementioned face.

According to a ninth aspect of the present invention, which is in accordance with any of the first to eighth aspects, the aerosol-generating device further comprises a tactile switch, and the display window portion functions as the button for switching the tactile switch.

According to a 10th aspect of the present invention, which is in accordance with any of the first to ninth aspects, the aerosol-generating portion comprises a heating unit for heating an aerosol-generating article, and the control unit is configured to start heating in the heating unit when the display window portion is continuously pressed for a predetermined time. According to an 11th aspect of the present invention, which is in accordance with any of the first to 10th aspects, the display portion comprises an organic light-emitting diode. According to a 12th aspect of the present invention, which is in accordance with any of the first to 11th aspects, the control unit is configured to display information relating to control of the aerosol-generating device on the display portion.

According to a 13th aspect of the present invention, which is in accordance with any of the first to 12th aspects, the display portion comprises a screen, and the first cushioning material extends in a direction in which the screen extends and has an opening portion at a position facing the screen in a direction perpendicular to the screen.

According to a 14th aspect of the present invention, which is in accordance with the 13th aspect, the display portion cover member is arranged, so as to face a direction perpendicular to the screen, on a member of the display portion arranged so as to surround the screen.

According to a 15th aspect of the present invention, an aerosol-generating system comprises the aerosol-generating device of any of the first to 14th aspects, and an aerosol-generating article.

### REFERENCE SIGNS LIST

10: Battery
20: Control unit
21: Tactile switch
30: Aerosol-generating portion
40: Heating unit
100: Aerosol-generating system
101: Upper face
110: Aerosol-generating article
120: Aerosol-generating device
121: Housing
122: Opening
200: Display assembly
210: Display window portion
211: Button portion
220: First cushioning material
221: First opening portion
230: Display portion cover member
231: Second opening portion
232: Leg portion
240: Second cushioning material
241: Third opening portion
250: Display portion
251: Screen
252: Frame member
300: Chassis

## Claims

1. An aerosol-generating device comprising: an aerosol-generating portion for generating an aerosol;
a battery;
a control unit;
a display portion;
a display window portion functioning as a button;
a display portion cover member positioned between the display window portion and the display portion; and
a first cushioning material positioned between the display window portion and the display portion cover member.

2. The aerosol-generating device as claimed in claim 1, wherein the first cushioning material comprises a silicone resin.

3. The aerosol-generating device as claimed in claim 1 or 2, further comprising a second cushioning material positioned between the display portion cover member and the display portion.

4. The aerosol-generating device as claimed in claim 3, wherein the second cushioning material comprises an ethylene-vinyl acetate copolymer resin.

5. The aerosol-generating device as claimed in claim 3 or 4, wherein the second cushioning material has a spongy structure, and the first cushioning material does not have a spongy structure.

6. The aerosol-generating device as claimed in any one of claims 1 to 5, wherein the display portion cover member comprises at least one of polycarbonate and ABS resin.

7. The aerosol-generating device as claimed in any one of claims 1 to 6, wherein
the display portion cover member comprises a leg portion extending to the opposite side of the display portion to the side on which the display portion cover member is disposed, and the leg portion is fixed to a chassis or a housing of the aerosol-generating device.

8. The aerosol-generating device as claimed in any one of claims 1 to 7,
further comprising a face having an opening through which a consumable material is inserted, wherein
the display window portion is arranged on the abovementioned face.

9. The aerosol-generating device as claimed in any one of claims 1 to 8,
further comprising a tactile switch, wherein
the display window portion functions as the button for switching the tactile switch.

10. The aerosol-generating device as claimed in any one of claims 1 to 9, wherein
the aerosol-generating portion comprises a heating unit for heating an aerosol-generating article, and
the control unit is configured to start heating in the heating unit when the display window portion is continuously pressed for a predetermined time.

11. The aerosol-generating device as claimed in any one of claims 1 to 10, wherein the display portion comprises an organic light-emitting diode.

12. The aerosol-generating device as claimed in any one of claims 1 to 11, wherein the control unit is configured to display information relating to control of the aerosol-generating device on the display portion.

13. The aerosol-generating device as claimed in any one of claims 1 to 12, wherein
the display portion comprises a screen, and
the first cushioning material extends in a direction in which the screen extends and has an opening portion at a position facing the screen in a direction perpendicular to the screen.

14. The aerosol-generating device as claimed in claim 13, wherein the display portion cover member is arranged, so as to face a direction perpendicular to the screen, on a member of the display portion arranged so as to surround the screen.

15. An aerosol-generating system comprising: the aerosol-generating device as claimed in any one of claims 1 to 14; and
an aerosol-generating article.
